# EUROPÄISCHE PATENTANMELDUNG

(11) **EP 1 701 603 A1**
(43) Veröffentlichungstag der Anmeldung: **13.09.2006**
(21) Anmeldenummer: 05007706.4
(22) Anmeldetag: 08.04.2005
(51) Int. Cl.: H05K 7/14, G06F 1/18

(54) **Vorrichtung zum Ein- und Aushebeln einer Steckbaugruppe**

(30) Priorität: 10.03.2005 DE 202005004039 U
(71) Anmelder: Schroff GmbH, D-75334 Straubenhardt (DE)
(72) Erfinder: Joist, Michael, 76571 Gaggenau (DE); Rutherford, Paul, 76228 Karlsruhe (DE); Euchner, Heinz, 75217 Birkenfeld (DE); Thalau, Klaus-Michael, 76316 Malsch (DE)
(74) Vertreter: Durm, Frank

(57) **Zusammenfassung**

Eine Vorrichtung zum Ein- und Aushebeln einer Steckbaugruppe in bzw. aus einem Baugruppenträger umfasst einen im Frontbereich der Steckbaugruppe (1) angeordnetes Eckstück (3) und einen Hebelziehgriff mit einem an dem Eckstück (3) schwenkbar gelagerten Hebel (6), dessen kurzer Hebelarm (12) sich gegen ein Querprofil (35) des Baugruppenträgers abstützt. Auf dem langen Hebelarm (13) des Hebel (6) ist ein Griffstück (7) drehbar so gelagert, dass es in unterschiedlichen Winkelpositionen kraftschlüssig mit dem Hebelarm (13) verbindbar ist, um den Hebel (6) zu verschwenken. Das Griffstück (7) ist in Längsrichtung verschieblich zwischen einer Ausgangslage, in der das Griffstück (7) frei drehbar ist, und einer Eingriffslage, in der das Griffstück (7) mit dem Hebelarm (13) kraftschlüssig verbunden ist.

## Beschreibung

Die Erfindung betrifft eine Vorrichtung zum Ein- und Aushebeln einer Steckbaugruppe in bzw. aus einem Baugruppenträger, umfassend ein im Frontbereich der Steckbaugruppe angeordnetes Eckstück und einen Hebelziehgriff mit einem an dem Eckstück schwenkbar gelagerten Hebel, dessen kurzer Hebelarm sich gegen ein Querprofil des Baugruppenträgers abstützt.

Bei modular aufgebauten elektronischen Geräten ist es heute üblich, die einzelnen Elektronikmodule als Steckbaugruppen auszuführen. Eine solche Steckbaugruppe weist an ihrem hinteren Ende einen vielpoligen Steckverbinder auf, der in eine korrespondierende Steckerleiste auf der Rückverdrahtungsplatte, der sogenannten Backplane, des Baugruppenträgers eingesteckt wird. Zum Herstellen wie auch zum Lösen der Steckverbindung müssen beträchtliche mechanische Kräfte überwunden werden, die von der Art des verwendeten Steckverbinders und insbesondere von der Anzahl der Kontakte abhängen. Bei elektromagnetisch abgeschirmten Steckbaugruppen müssen zudem die Reibungskräfte der EMV-Dichtungen zwischen den einzelnen Steckbaugruppen bzw. der Steckbaugruppe und dem Baugruppenträger überwunden werden.

Zur Überwindung der Kräfte beim Einstecken und Ausziehen ist im Frontbereich der Steckbaugruppe wenigstens ein Hebelziehgriff vorgesehen, mit dessen Hilfe die Steckbaugruppe in den Baugruppenträger eingehebelt oder aus diesem herausgehebelt werden kann.

Gehört die Steckbaugruppe zu einem Bus-System, wird beim Ein- bzw. Aushebeln zugleich ein Mikroschalter betätigt, der die Stromzuführung aktiviert bzw. deaktiviert. So kann die elektronische Baugruppe im laufenden Betrieb eingesetzt oder ausgewechselt werden. Diese sogenannte Hot-Swap-Funktion wird in vielen Spezifikationen für modulare Aufbausysteme vorgeschrieben, beispielsweise in der Telekommunikation.

Vorgeschrieben oder zumindest gewünscht ist ferner eine mechanische Verriegelung des Hebelziehgriffs, um ein unbeabsichtigtes Aushebeln und damit eine Trennung der Steckbaugruppe vom Bus zu verhindern.

Hebelziehgriffe zum Ein- und Aushebeln einer Steckbaugruppe, mit und ohne automatischer Aktiv-Passiv-Schaltung und/oder Verriegelung, gibt es in vielfältigen Ausführungen. Je nach Anwendungsfall unterscheiden sie sich hinsichtlich des Drehwinkels, des Hubs, der Übersetzungsverhältnisse, der Bedienungsweise und der optischen Erscheinung.

So ist aus der EP 1 499 171 A1 eine Ein- und Ausziehvorrichtung einer Steckbaugruppe bekannt, bei dem am Griffarm des Hebelziehgriffs ein Sperrhebel drehbar angelenkt ist, mit dessen Hilfe der Hebelziehgriff gegen Verschwenken gesperrt werden kann.

Einen ähnlichen Hebelziehgriff offenbart EP 1 463 394 A1. Der Griffarm des Hebelziehgriffs trägt einen drehbar angelenkten Schalthebel mit einer Schaltklinke, durch welche bei vollständig eingesteckter Steckbaugruppe ein Mikroschalter betätigbar ist. Die Schaltklinke des Schalthebels weist ferner eine Rastnase auf, die hinter einer Rastkante im Frontbereich der Steckbaugruppe einrastbar ist, um den Hebelziehgriff gegen Verschwenken zu sperren.

Die Patentschrift US 6 685 489 B1 und die zugehörige Offenlegungsschrift DE 103 27 948 A1 beschreiben einen Hebelwirkungsmechanismus für Schaltungsplatinen mit einem Zahnradgetriebe.

Vorliegend geht es speziell um Hebelziehgriffe für moderne Telekommunikations-Systeme nach dem von der PICMIG (PCI Industrial Computing Manufactory Group) entwickelten ATCA-Standard (Advanced Telecom Computing Architecture). Dort wird vorgeschrieben, dass die Drehbewegung des Hebelziehgriffs 75° betragen soll. Gleichzeitig werden für die Drehbewegung des Griffes eine obere und eine untere horizontale Begrenzungslinie vorgegeben, wobei die obere Begrenzungslinie den Einbau einer Sub-Baugruppe (sogenanntes AMC-Modul) knapp über dem Eckstück der Steckbaugruppe ermöglichen soll. Die untere Begrenzungslinie soll der Vermeidung von Kollisionen des Hebelziehgriffs mit unterhalb der Steckbaugruppe vorhandenen Teilen, wie zum Beispiel einer Kabelwanne gewährleisten.

Es stellt sich somit das technische Problem, einen Hebelziehgriff für elektronische Steckbaugruppen so auszugestalten, dass unter weitgehender Beibehaltung der üblichen normgerechten Hebelgeometrie und unverändert großer Hebelwirkung der für das Verschwenken des Hebelziehgriffs freizuhaltende Bereich über und unter der Schwenkachse in möglichst engen Grenzen bleibt, insbesondere innerhalb einer oberen und einer unteren Begrenzungslinie parallel zur Einschubrichtung.

Ausgehend von einer Vorrichtung der eingangs beschriebenen Art wird die Aufgabe gelöst durch ein auf dem langen Hebelarm des schwenkbaren Hebels drehbar gelagertes Griffstück, das in unterschiedlichen Winkelpositionen kraftschlüssig mit dem Hebelarm so verbindbar ist, dass ein Benutzer durch Anfassen des Griffstücks den Hebel verschwenken und die Steckbaugruppe ein- bzw. aushebeln kann.

Erfindungsgemäß ist der lange Hebelarm des Hebels zweiteilig ausgebildet, wobei das Griffstück gelenkig an den langen Hebelarm angesetzt ist. Dies ermöglicht ein Umsetzen des Griffstücks in unterschiedliche Winkelpositionen relativ zum Hebelarm. Dadurch kann der in der Höhe begrenzte Raum, der als Schwenkbereich zugelassen wird, mehrfach ausgenutzt werden. Beispielsweise kann das Griffstück zunächst in eine horizontale Position gebracht und dann mit dem Hebelarm kraftschlüssig verbunden werden. Nach einer gewissen Verschwenkung des Hebels wird die kraftschlüssige Verbindung zum Griffstück gelöst und das Griffstück entgegen der Drehrichtung des Hebels verdreht, anschließend erneut kraftschlüssig mit dem Hebelarm verbunden. Je länger das Griffstück ist und je enger die Begrenzung des Schwenkbereichs, desto öfter muss das Griffstück umgesetzt werden, bis der Hebel in seine Endlage verschwenkt und damit die Steckbaugruppe vollständig ausgehebelt ist.

Ein großer Vorteil des erfindungsgemäßen Hebelziehgriffs besteht darin, dass die normgerechte Geometrie des Hebels selbst nicht verändert wird, insbesondere also der übliche Drehwinkel von ca. 75 ° beibehalten wird, obwohl das Griffstück beispielsweise nur um maximal 45° gegenüber der Horizontalen verdreht wird.

Bei einer bevorzugten Ausführung der Erfindung lässt sich das Griffstück nur bei bestimmten ausgewählten Winkelpositionen kraftschlüssig mit dem Hebelarm verbinden. Anzahl und Lage der Winkelpositionen richten sich nach den Begrenzungslinien des Bereichs, in dem sich das Griffstück bewegen darf. Bei Verwendung eines gut handhabbaren Griffstücks mittlerer Länge genügen beispielsweise drei unterschiedliche Winkelpositionen, um die Steckbaugruppe vollständig ein- oder auszuhebeln.

Besonders bevorzugt wird eine Ausführung, bei der das Griffstück nicht nur drehbar, sondern zudem in Längsrichtung verschieblich auf dem Hebelarm gelagert ist. Das Griffstück lässt sich dann zwischen einer Ausgangslage, in der es gegenüber dem Hebelarm frei drehbar ist, und einer Eingriffslage, in der das Griffstück mit dem Hebelarm durch Formschluss verbunden ist, hin- und herbewegen. Eine solche Verschiebbarkeit in Längsrichtung lässt sich beispielsweise dadurch erzielen, dass das Griffstück ein Langloch aufweist, und dass an dem langen Hebelarm eine Lagerachse vorgesehen ist, welche in das Langloch des Griffstücks eingreift. Natürlich kann auch umgekehrt das Langloch am Hebelarm und die Lagerachse am Griffstück vorgesehen sein. Wird das Griffstück in Längsrichtung verschoben, so wechselt die Lagerachse vom einen in das andere Ende des Langlochs, wobei die Länge des Langlochs den Hub begrenzt. Dabei kann das Griffstück durch eine Feder in der Ausgangslage gehalten werden, in der es frei drehbar ist. Gegen die Wirkung dieser Feder wird dann das Griffstück nach vorne, das heißt also in Richtung der Frontplatte, in die Eingriffslage gedrückt, um eine kraftschlüssige Verbindung mit dem Hebelarm herzustellen.

In vorteilhafter und zweckmäßiger Weiterbildung der Erfindung sind an dem Griffstück und dem langen Hebelarm des Hebels korrespondierende Mittel zur Herstellung einer formschlüssigen Verbindung vorgesehen, wobei der Formschluss hergestellt wird, sobald sich das Griffstück in Eingriffslage befindet. Zum Beispiel kann der lange Hebelarm eine Kulissenführung aufweisen, in die ein Mitnehmer des Griffstücks eingreift. Mittels einer solchen Kulissenführung lassen sich einige wenige ausgewählte Winkelpositionen vorgeben, in denen das Griffstück durch Formschluss eine Kraftübertragung auf den Hebelarm zulässt. Eine der durch die Kulissenführung möglichen Winkelpositionen des Griffstücks, beispielsweise die horizontale Position, kann zum Verriegeln bzw. Entriegeln des Hebels benutzt werden. Dieselbe Winkelposition kann auch gleichzeitig zur Aktiv- bzw. Passiv-Schaltung der elektronischen Baugruppe durch Drücken des Griffstücks benutzt werden. Daneben können beispielsweise zwei weitere Winkelpositionen vorgegeben werden, die nur dem Verschwenken des Hebels dienen.

Um die ausgewählten Winkelpositionen leicht anfahren zu können, kann der lange Hebelarm und das Griffstück mit korrespondierenden Rastmitteln versehen sein, welche das Griffstück in den vorgegebenen Winkelpositionen fixiert. Dabei entsprechen zweckmäßig zumindest einige der durch die Rastmittel vorgegebenen Winkelpositionen den ausgewählten Winkelpositionen, in denen das Griffstück mit dem Hebelarm formschlüssig verbindbar ist. Es können zusätzliche weitere Winkelpositionen vorgegeben werden, in die das Griffstück gedreht werden kann, ohne dass eine formschlüssige Verbindung mit dem Hebelarm möglich wäre, beispielsweise in verschiedene Ruhepositionen.

Eine weitere vorteilhafte Ausführungsform der Erfindung ist gekennzeichnet durch eine am Eckstück der Steckbaugruppe in Längsrichtung verschieblich gelagerte Schubstange, die den Hebel gegen Verschwenken verriegelt, wobei diese Schubstange durch das Griffstück aus der Verriegelungslage in eine Entriegelungslage verschiebbar ist, wenn sich das Griffstück in einer der ausgewählten Winkelpositionen befindet. Hierdurch wird eine automatische Entriegelung des Hebelziehgriffs unmittelbar vor dem ersten Verschwenken des Hebels möglich.

Gleichzeitig ist ein unbeabsichtigtes Entriegeln ausgeschlossen. Die Schubstange kehrt in die Verriegelungslage zurück, wenn die Steckbaugruppe vollständig eingehebelt ist.

Die Schubstange kann zudem einen Mikroschalter zum Aktiv- bzw. Passiv-Schalten der Steckbaugruppe betätigen. Dabei ist im Normalfall, das heißt bei vollständig eingesteckter Steckbaugruppe, der Mikroschalter EIN geschaltet, wohingegen der Mikroschalter AUS geschaltet und dadurch die Steckbaugruppe stromlos wird, sobald das Griffstück in einer ausgewählter Winkelposition mit dem Hebel kraftschlüssig bzw. formschlüssig verbunden und dabei die Schubstange nach hinten geschoben wird.

Eine automatische Verriegelung des Hebelziehgriffs mit gleichzeitiger Aktiv-Schaltung der Steckbaugruppe nach dem vollständigen Einhebeln kann auf einfache Weise dadurch erreicht werden, dass die Schubstange durch eine Feder in Richtung der Frontplatte der Steckbaugruppe gezogen wird. Sobald das Griffstück aus seiner Eingriffslage in die Ausgangslage zurückkehrt, folgt ihm die Schubstange unter der Wirkung der Feder, wodurch sowohl der Hebelarm gegen Verschwenken verriegelt als auch der Mikroschalter in die Stellung EIN gebracht wird.

Ein Ausführungsbeispiel der Erfindung wird nachstehend anhand der beigefügten Zeichnungen näher erläutert. Es zeigen:
- Figuren 1a, 1b: die vordere untere Ecke einer Steckbaugruppe mit angebautem Hebelziehgriff, in zwei perspektivischen Ansichten schräg von oben bzw. unten;
- Figuren 2a, 2b: den Hebel des Hebelziehgriffs;
- Figuren 3a, 3b: das Griffstück des Hebelziehgriffs;
- Figuren 4a, 4b: die Schubstange des Hebelziehgriffs;
- Figur 5: den Hebelziehgriff mit Hebel, Griffstück und vorderem Ende der Schubstange, in teilweise geschnittener Seitenansicht;
- Figuren 6a, 6b: die vollständig in einen Baugruppenträger eingeschobene Steckbaugruppe, in einer teilweise geschnittenen Seitenansicht;
- Figuren 7a, 7b: den Beginn des Aushebelns der Steckbaugruppe;
- Figuren 8a - 8d: die teilweise ausgehebelte Steckbaugruppe;
- Figuren 9a - 9d: die weiter ausgehebelte Steckbaugruppe;
- Figuren 10a, 10b: die vollständig ausgehebelte Steckbaugruppe.

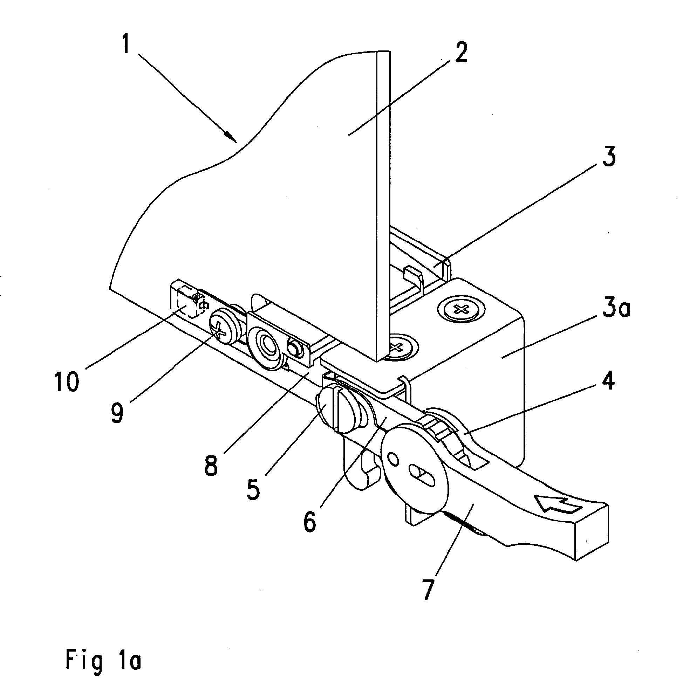

In den perspektivischen Ansichten von Fig. 1a und 1b ist nur der vordere untere Eckbereich einer elektronischen Steckbaugruppe 1 zu sehen. Diese hat eine Leiterplatte 2, auf der die elektronischen Bauelemente angeordnet sind. Ein Eckstück 3, das auch als Lagerknoten oder englisch "strut" bezeichnet wird, ist mit der Leiterplatte 2 verschraubt. Das Eckstück 3 trägt eine kurze Teilfrontplatte 3a. Ein als Ganzes mit dem Bezugszeichen 4 bezeichneter Hebelziehgriff ist mittels einer Lagerschraube 5 an das Eckstück 3 angeschraubt und lässt sich um eine Achse quer zur Leiterplatte 2 verschwenken. Die nicht sichtbare obere Ecke der Steckbaugruppe 1 ist in gleicher Weise spiegelbildlich ausgebildet.

Der Hebelziehgriff 4 besteht im Wesentlichen aus zwei beweglichen Teilen, nämlich einem Hebel 6 und einem Griffstück 7, das drehbar und in Längsrichtung verschieblich auf dem Hebel 6 gelagert ist. Seitlich ist eine mehrfach abgewinkelte Schubstange 8 angeordnet, die vorne gemeinsam mit dem Hebel 6 durch die Lagerschraube 5 und hinten durch eine zweite Lagerschraube 9 längs verschieblich gelagert ist. Die Schubstange 8 kann durch Drücken des Griffstücks 7 in der mit dem Pfeil markierten Richtung nach hinten verschoben werden, um einen im Bereich des hinteren Endes der Schubstange 8 angeordneten Mikroschalter 10 zu betätigen. Dieser Mikroschalter 10 schaltet die Stromversorgung der Steckbaugruppe 1 ein oder aus. Eine Zugfeder 11 (siehe Figur 1b) zieht die Schubstange 8 nach vorne auf das Griffstück 7 hin.

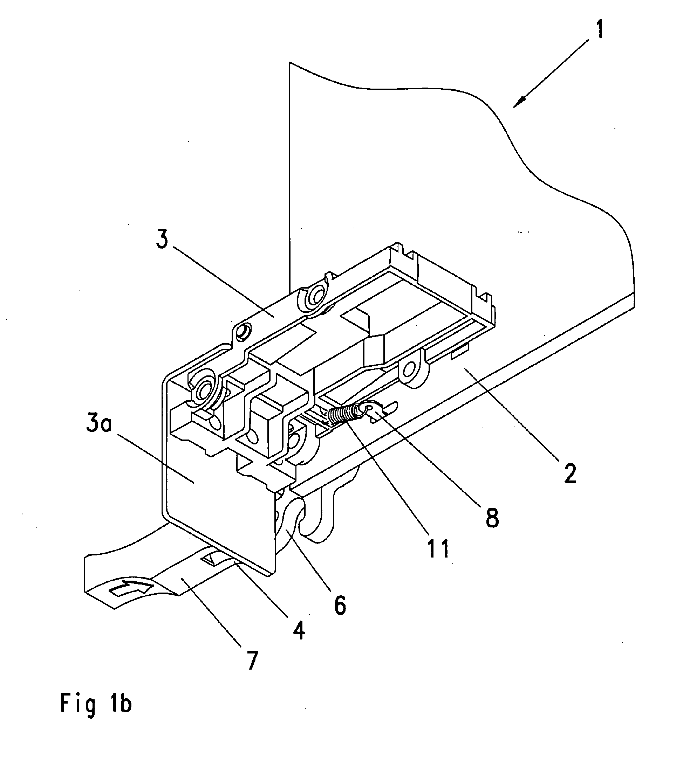

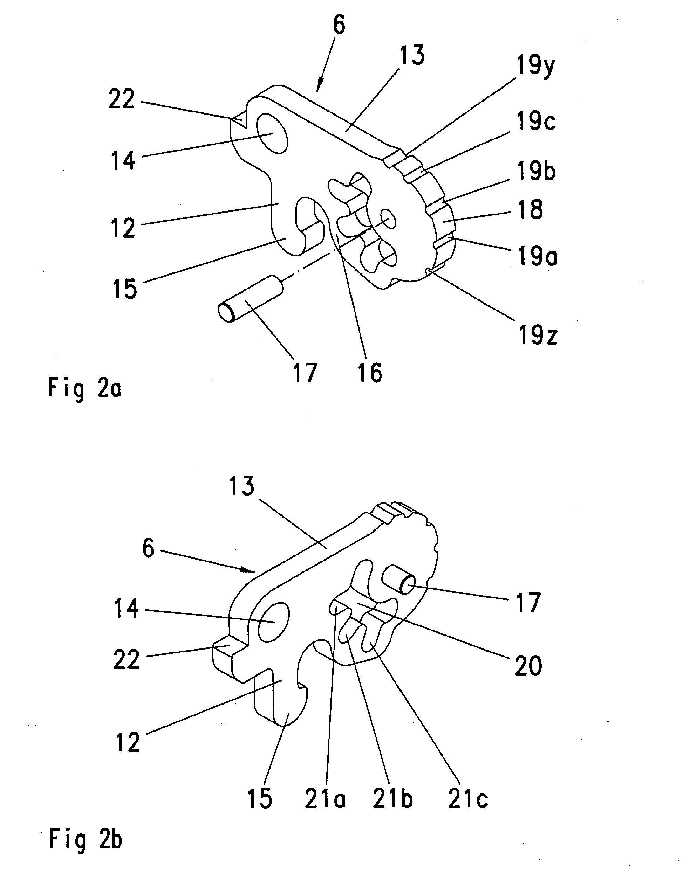

In den Figuren 2a und 2b ist der Hebel 6 des Hebelziehgriffs 4 alleine zu sehen, und zwar in Figur 2a in einer Ansicht schräg von vorne, entsprechend dem Blickwinkel von Figur 1a, und in Figur 2b schräg von hinten. Der Hebel 6 ist im Wesentlichen einstückig als Druckgußteil aus Metall hergestellt. Seine Form ist im Prinzip L-förmig, wobei der kleine L-Schenkel den kurzen Hebelarm 12 und der große L-Schenkel den langen Hebelarm 13 bildet. Im Schnittpunkt der beiden Schenkel befindet sich eine Lagerbohrung 14. Am freien Ende des kurzen Hebelarms 12 ist eine Ein-/Aushebelnase 15 angeformt, der eine gebogene Abdrückschulter 16 gegenüberliegt. In einigem Abstand zu dem freien Ende des langen Hebelarms 13 ist eine Lagerachse 17 eingesteckt, die parallel zur Lagerbohrung 14 verläuft. Das freie Ende des langen Hebelarms 13 hat die Kontur eines Halbkreises mit der Lagerachse 17 als Mittelpunkt und bildet eine Gleitfläche 18, über die drei Rastnuten 19a, 19b, 19c und zwei zusätzliche äußere Rastnuten 19y, 19z verteilt sind. Auf der anderen Seite der Lagerachse 17 ist ein kreisförmig gebogener Zentralschlitz 20 eingebracht, der gleichfalls zentrisch, aber in etwas geringerem Abstand um die Lagerachse 17 verläuft. Von dem Zentralschlitz 20 gehen drei Radialschlitze 21a, 21b, 21c aus, die untereinander gleichen Abstand haben und radial zur Lagerachse 17 ausgerichtet sind. Der Zentralschlitz 20 und die Radialschlitze 21a, 21b, 21c bilden eine Kulissenführung. In der Nähe der Lagerbohrung 14 ist ein Vorsprung mit einer horizontalen Anschlagfläche 22 ausgebildet.

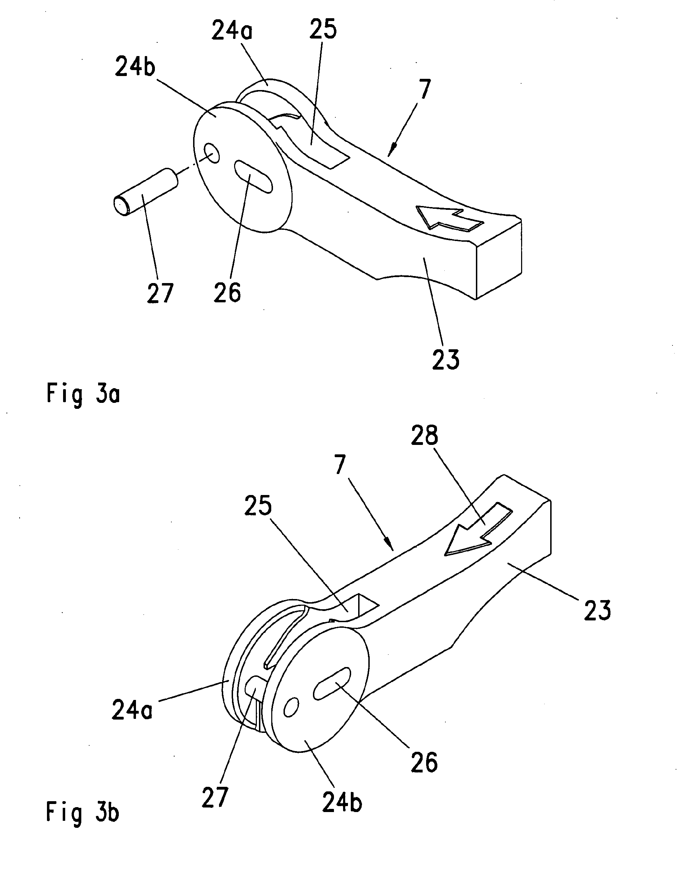

In den Figuren 3a und 3b ist das Griffstück 7 herausgezeichnet, und zwar in Figur 3a unter demselben Blickwinkel wie die Ansicht von Figur 1a, und in Figur 3b schräg von hinten. Das Griffstück 7 ist aus Kunststoff spritzgegossen. Das vordere Ende ist als Griff 23 ausgeformt. Das andere Ende ist in der Art einer Gabel ausgebildet und umfasst zwei runde Seitenteile 24a und 24b, die einen Aufnahmeschlitz 25 einschließen. Die Seitenteile 24a, 24b weisen jeweils ein Langloch 26 auf, dessen hinteres Ende im Zentrum der kreisförmigen Seitenteile 24a, 24b liegt und die Drehachse des Griffstücks 7 definiert. In der Verlängerung des Langlochs 26 ist ein Mitnehmerstift 27 in entsprechende Bohrungen der Seitenteile 24a, 24b eingesetzt. Der Pfeil 28 gibt die Richtung an, in der das Griffstück 7 durch Drücken längs verschoben werden kann.

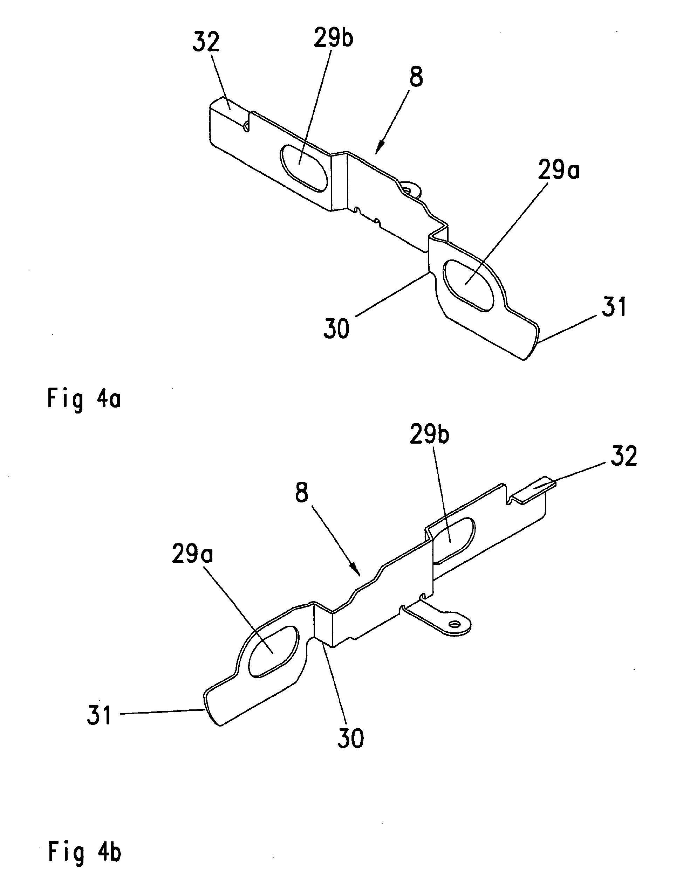

Die Figuren 4a und 4b zeigen die Schubstange 8 im Detail, wobei der Blickwinkel der Figur 4a wiederum demjenigen der Figur 1a entspricht und Figur 4b die Schubstange 8 von der Rückseite zeigt. Die Schubstange 8 ist als Stanz-Biegeteil aus dünnem Stahlblech hergestellt. Ein vorderes Langloch 29a und ein hinteres Langloch 29b dienen der in Längsrichtung verschieblichen Lagerung am Eckstück 3 der Steckbaugruppe 1 mittels der Lagerschrauben 5 und 9 (vgl. Figur 1a). In einem mittleren Abschnitt ist die Schubstange 8 zwei Mal Z-förmig abgekantet, wobei die erste vordere Abkantung einen Sperrabsatz 30 bildet. Das vordere Ende ist als gekrümmter Nocken 31 ausgebildet. Am hinteren Ende ist durch Abkantung eine horizontale Schaltfläche 32 ausgebildet.

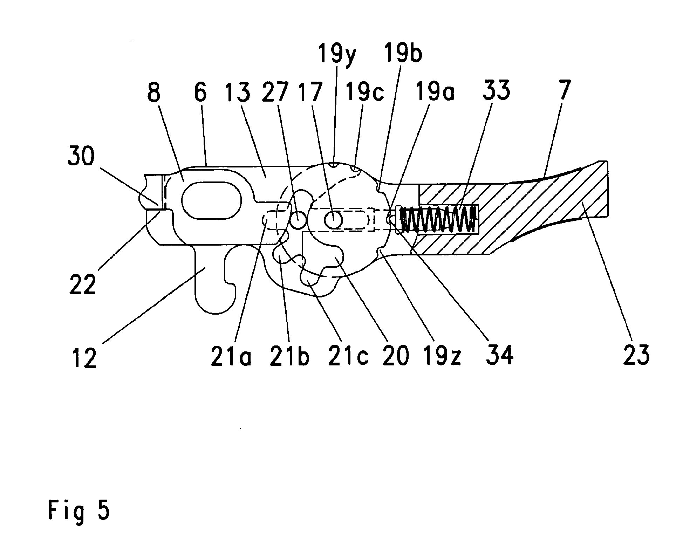

Aus Figur 5 wird die Funktionen und das Zusammenwirken des Hebels 6, des Griffstücks 7 und der Schubstange 8 deutlich: Das Griffstück 7 ist auf dem langen Hebelarm 13 des Hebels 6 drehbar und in Längsrichtung verschiebbar gelagert, indem die Lagerachse 17 des Hebels 6 in das Langloch 26 des Griffstücks 7 eingreift. Das Griffstück 7 befindet sich hier in einer Ruheposition in horizontaler Ausgangslage. Die Lagerachse 17 befindet sich im hinteren (linken) Ende des Langlochs 26. Der Mitnehmerstift 27 des Griffstücks 7 ist im Zentralschlitz 20 des Hebels 6 auf einer Kreisbahn frei beweglich. Im Innern des Griffstücks 7 ist eine Druckfeder 33 eingebaut, die einen Raststift 34 gegen die Gleitfläche 18 am freien Ende des langen Hebelarms 13 drückt. Die drei Rastnuten 19a, 19b, 19c sind den drei Radialschlitzen 21a, 21b, 21c zugeordnet und sind mit diesen in einer Linie angeordnet. Auf diese Weise lässt sich das drehbare Griffstück 7 in drei verschiedenen, durch die Rastnuten 19a, 19b, 19c vorgegebenen Winkelpositionen fixieren, in denen der Mitnehmerstift 27 vor einem der drei Radialschlitze 21a, 21b, 21c steht. Die zusätzlichen Rastnuten 19y und 19z geben Ruhepositionen vor.

In Figur 5 befindet sich die Schubstange 8 in ihrer vorderen Endlage. Dabei liegt die Anschlagfläche 22 des Hebels 6 gegen den Sperrabsatz 30 der Schubstange 8 an. Der Hebel 6 ist dadurch verriegelt, kann also nicht um seine Schwenkachse verdreht werden.

Anhand der weiteren Abbildungen ab Figur 6a wird im Folgenden beschrieben, wie die Steckbaugruppe 1 mittels des Hebelziehgriffs 4 aus einem Baugruppenträger ausgehebelt wird.

Figur 6a zeigt den unteren Eckbereich der Steckbaugruppe 1 vollständig in den Baugruppenträger eingeschoben, von dem nur das U-Profil eines vorderen Querprofilträgers 35 zu sehen ist. Eine horizontale obere Begrenzungslinie 36 und eine hierzu parallele untere Begrenzungslinie 37 begrenzen den Freiraum, innerhalb dem sich der Hebelziehgriff 4 bewegen darf. Der Hebel 6 befindet sich in seiner horizontalen Ruhestellung (0°). Das Griffstück 7 befindet sich ebenfalls in horizontaler Winkelposition, was die Standardlage ist, die den Einbau eines Sub-Moduls in die Steckbaugruppe 1 unmittelbar über der oberen Begrenzungslinie 36 erlaubt. Das Griffstück 7 befindet sich dabei in seiner Ausgangslage in Bezug auf den Hebel 6. Die Lagerachse 17 sitzt im hinteren Ende des Langlochs 26 (in der Zeichnung links). Die Schubstange 8 ist ganz nach vorne geschoben (in der Zeichnung rechts). Der Sperrabsatz 30 der Schubstange 8 liegt an der Anschlagfläche 22 des Hebels 6 an. Dadurch ist der Hebel 6 verriegelt. Der Raststift 34 sitzt in der Rastnut 19a an der Gleitfläche 18 und fixiert dadurch das Griffstück 7. Der Mitnehmerstift 27 befindet sich im Zentralschlitz 20. Der Mikroschalter 10 ist in Stellung EIN, die Steckbaugruppe 1 ist also aktiv geschaltet.

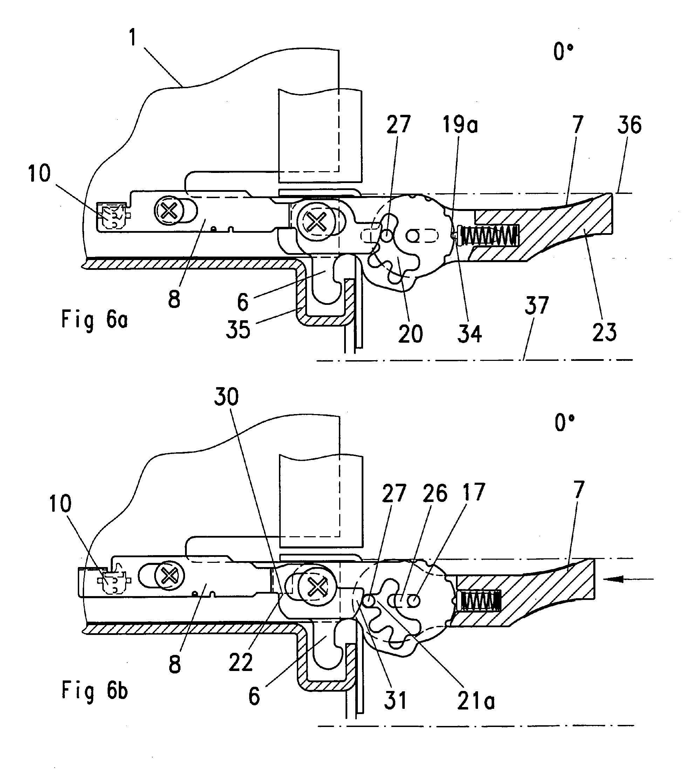

In Figur 6b wurde Druck in Richtung des Pfeils auf das Ende des Griffs 23 ausgeübt. Dadurch hat sich das Griffstück 7 in Längsrichtung aus der Ausgangslage in die Eingriffslage verschoben, bei ungeändert horizontaler Winkelposition. Die Lagerachse 17 hat in das vordere Ende (in der Zeichnung rechts) des Langlochs 26 gewechselt. Gleichzeitig hat sich der Mitnehmerstift 27 in den obersten Radialschlitz 21a bis zum Anstoß vorgeschoben. Das Griffstück 7 ist nun formschlüssig mit dem Hebel 6 verbunden, so dass sich auf das Griffstück 7 eingeleitete Drehkräfte auf den Hebel 6 übertragen. Gleichzeitig hat der Mitnehmerstift 27 durch Druck auf den Nocken 31 die Schubstange 8 nach hinten (in der Zeichnung links) verschoben. In dieser Entriegelungslage der Schubstange 8 hat sich der Sperrabsatz 30 von der Anschlagfläche 22 gelöst, so dass der Hebel 6 nunmehr frei ist. Der Mikroschalter 10 ist jetzt in Stellung AUS, die Steckbaugruppe 1 also bereits stromlos.

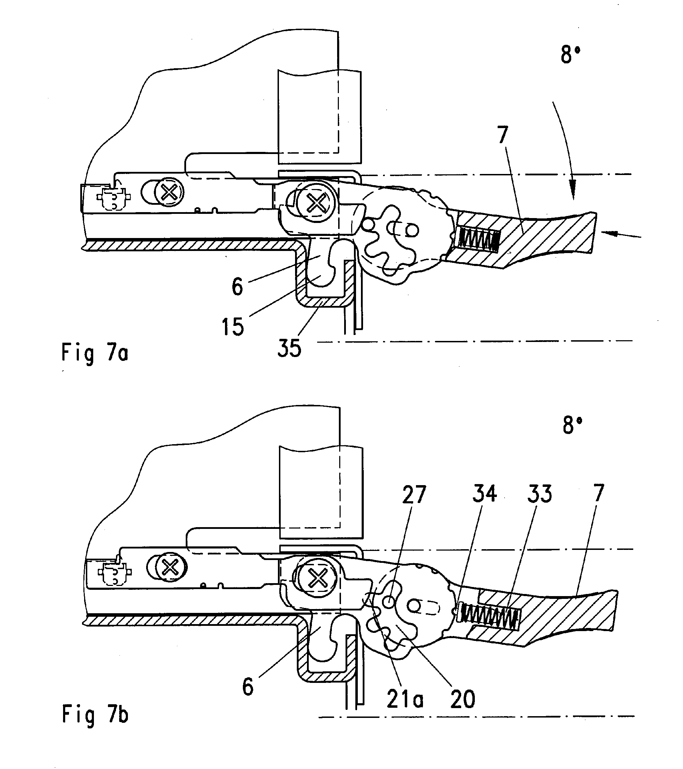

Figur 7a zeigt das Griffstück 7 und den damit formschlüssig verbundenen Hebel 6 um 8° gegenüber der Horizontalen verschwenkt. Die Aushebelnase 15 liegt jetzt an dem Querprofil 35 an und stützt sich gegen dessen hintere Wand ab.

In Figur 7b beträgt die Winkellage des Hebels 6 unverändert 8°. Das Griffstück 7 wurde losgelassen und ist durch die Wirkung der Druckfeder 33 in seine Ausgangslage zurückgekehrt, wodurch der Mitnehmerstift 26 aus dem obersten Radialschlitz 21a heraus und zurück in den Zentralschlitz 20 geglitten ist. Damit ist die formschlüssige Verbindung zwischen dem Griffstück 7 und dem Hebel 6 aufgehoben. Lediglich der durch die Druckfeder 33 belastete Raststift 34 verhindert, dass das Griffstück 7 seine horizontale Winkelposition relativ zum Hebel 6 verlässt. Die Anschlagfläche 22 des Hebels 6 hat sich gegenüber dem Sperrabsatz 30 der Schubstange 8 nach oben bewegt, so dass die Schubstange 8 nicht mehr zurückschnappen kann.

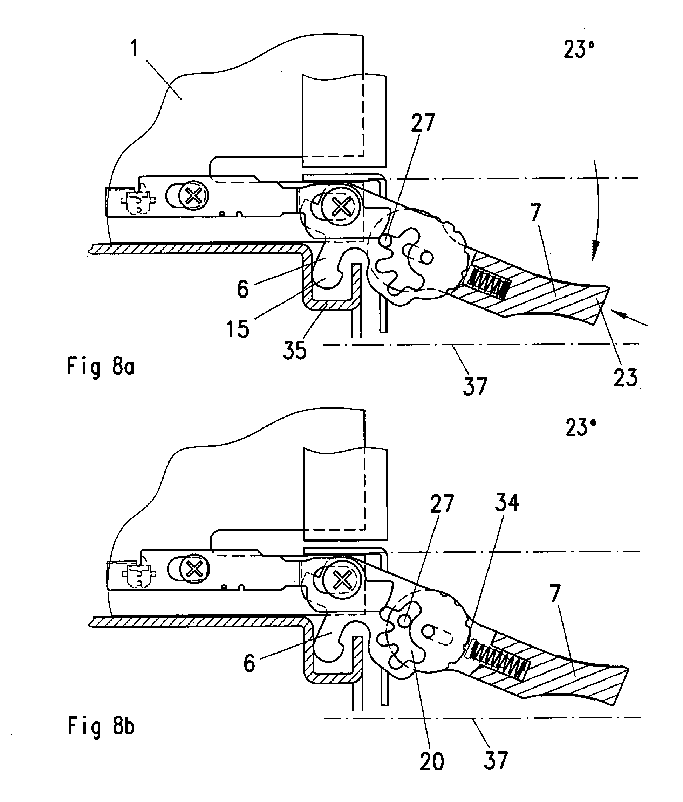

Ein erneuter Druck auf das Ende des Griffs 23 bringt das Griffstück 7 wieder in formschlüssige Verbindung mit dem Hebel 6. Wird nun das Griffstück 7 gemäß Figur 8a in Richtung des gebogenen Teils nach unten verschwenkt, so überträgt sich die Drehkraft über den eingerückten Mitnehmerstift 27 auf den Hebel 6, der dadurch im gleichen Drehsinn verschwenkt wird. Infolge der Abstützung der Aushebelnase 15 am Querprofil 35 beginnt sich die Steckbaugruppe 1 aus ihrem Steckplatz im Baugruppenträger zu lösen und nach vorne (in der Zeichnung rechts) zu bewegen.

Nach einer Verschwenkung des Hebels 6 um ca. 23° gegenüber der Horizontalen kommt das Ende des Griffs 23 in die Nähe der unteren Begrenzungslinie 37. Würde die Schwenkbewegung über die in Figur 8a dargestellte Lage hinaus fortgesetzt werden, würde die untere Begrenzungslinie 37 durchbrochen. Statt dessen kehrt das Griffstück 7 aus seiner Eingriffslage, in der es mit dem Hebel 6 kraft- und formschlüssig verbunden ist, in die Ausgangslage zurück, wie in Figur 8b dargestellt. Der Mitnehmerstift 27 befindet sich wieder im Zentralschlitz 20. Aus seiner nur lose durch den Raststift 34 fixierten Winkelposition kann das Griffstück 7 nun entgegen der bisherigen Schwenkrichtung, also nach oben, gedreht werden.

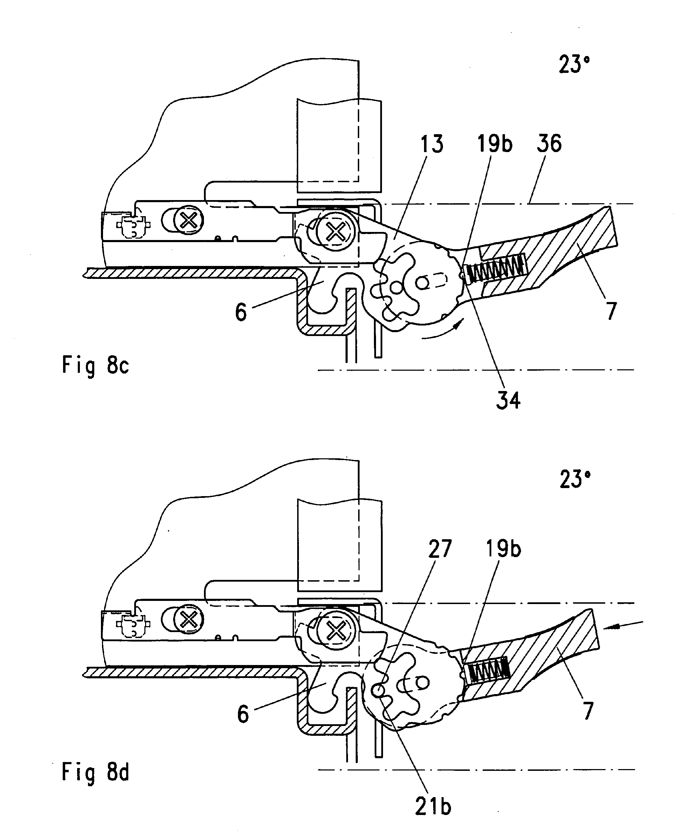

Figur 8c zeigt das um 33,5° zurückgedrehte Griffstück 7 bei unverändertem Schwenkwinkel des Hebels 6 von 23°. Das Griffstück 7 steht dadurch erstmals schräg nach oben gegenüber dem langen Hebelarm 13. Das Griffstück 7 stößt mit seiner äußeren oberen Ecke an die obere Begrenzungslinie 36. Der Raststift 34 sitzt jetzt in der mittleren Rastnut 19b.

Im nächsten, durch Figur 8d veranschaulichten Schritt befindet sich das Griffstück 7 wieder in formschlüssiger Verbindung mit dem Hebel 6. Der Mitnehmerstift 27 ist jetzt aber in den mittleren Radialschlitz 21b eingerückt, welche mit der mittleren Rastnut 19b korrespondiert.

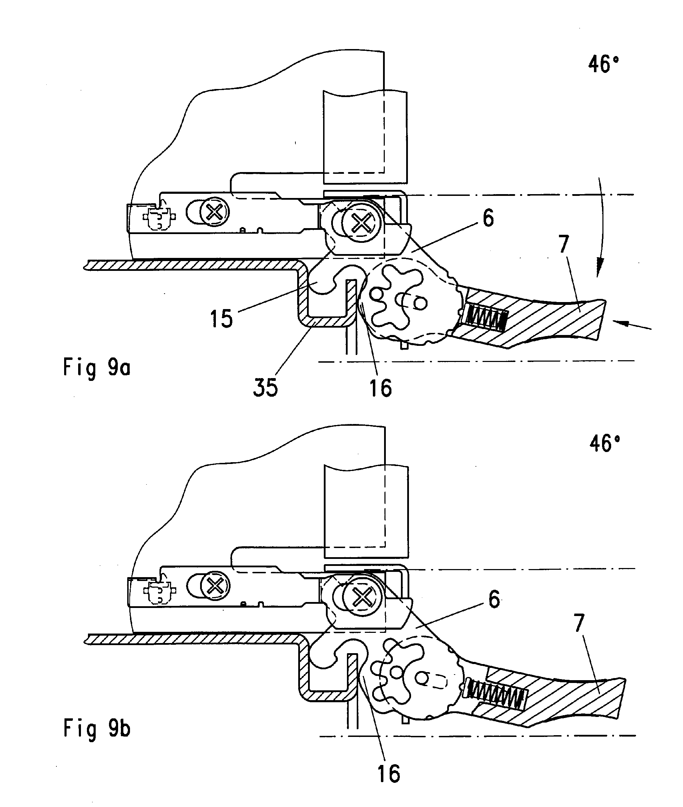

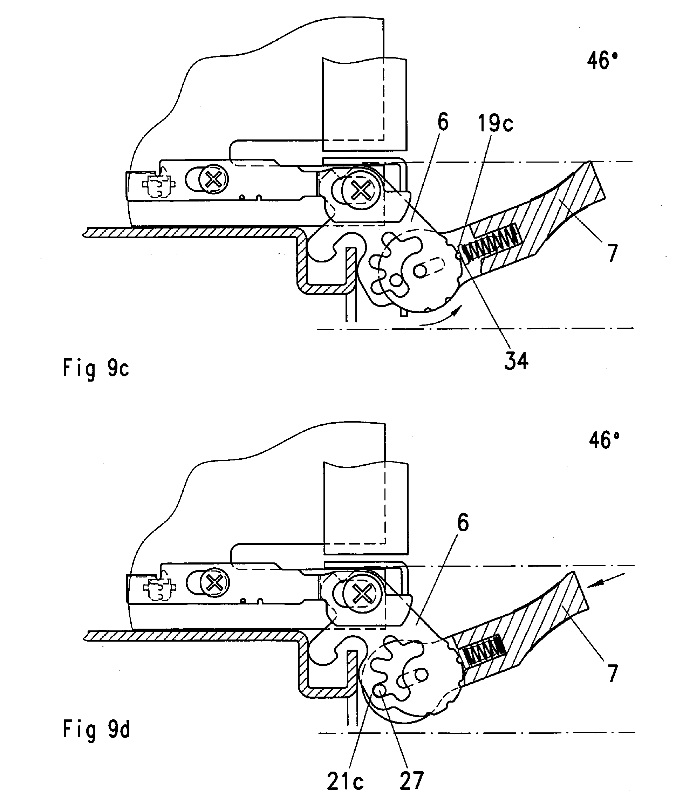

Nach dem zweiten Hinunterdrücken des Griffstücks 7 erreicht der Hebel 6 die in Figur 9a zu sehende Lage, in der er um 46° gegenüber der Horizontalen verschwenkt ist. Die Aushebelnase 15 hat sich im Querprofil 35 nach oben gearbeitet, wobei das Aushebeln durch die Abdrückschulter 16 unterstützt wird. Gleichzeitig hat sich die Steckbaugruppe 1 weiter nach vorne (in der Zeichnung rechts) bewegt.

In Figur 9b ist das Griffstück 7 durch die Druckfeder 33 wieder in die Ausgangslage zurückgekehrt, in der das Griffstück 7 gegenüber dem Hebel 6 frei drehbar ist.

Das Griffstück 7 kann jetzt zum zweiten Mal umgesetzt, das heißt zurückgedreht werden, bis es sich in der in Figur 9c dargestellten Winkelposition befindet. Der Raststift 34 rastet in die Rastnut 19c ein. Anschließend wird das Griffstück 7 wieder in formschlüssigen Eingriff mit dem Hebel 6 gebracht. Der Mitnehmerstift 27 rückt diesmal in den dritten untersten Radialschlitz 21c ein.

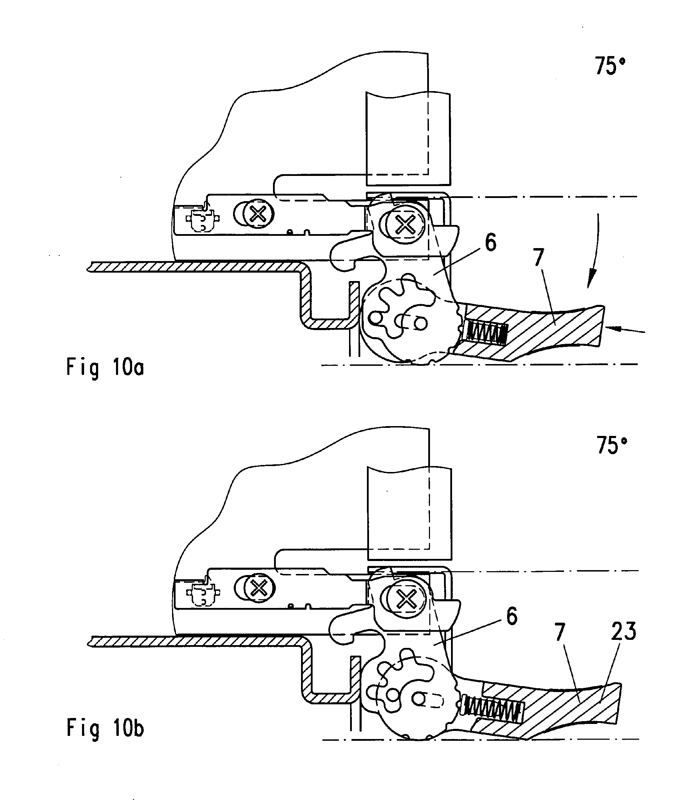

Das Griffstück 7 kann nun zum dritten Mal nach unten gedrückt werden, bis es die in Figur 10a zu sehende Lage einnimmt. Der Hebel 6 ist nun maximal, nämlich um 75° verschwenkt und die Steckbaugruppe 1 damit vollständig ausgehebelt.

Als Letztes wird der Griff 23 losgelassen, wodurch das Griffstück 7 seinen Formschluss mit dem Hebel 6 verliert und in die Ausgangslage zurückkehrt. Das Griffstück 6 könnte jetzt noch in eine beliebige Winkelposition verdreht, beispielsweise nach oben geklappt werden, damit es nicht stört.

Das Einhebeln der Steckbaugruppe 1 geschieht in grundsätzlich gleicher Weise, aber in umgekehrter Reihenfolge.

### Zusammenstellung der Bezugszeichen

- 1: Steckbaugruppe
- 2: Leiterplatte
- 3: Eckstück
- 4: Hebelziehgriff
- 5: Lagerschraube
- 6: Hebel (von 4)
- 7: Griffstück (von 4)
- 8: Schubstange
- 9: Lagerschraube
- 10: Mikroschalter
- 11: Zugfeder
- 12: kurzer Hebelarm (von 6)
- 13: langer Hebelarm (von 6)
- 14: Lagerbohrung
- 15: Ein-/Aushebelnase
- 16: Abdrückschulter
- 17: Lagerachse
- 18: Gleitfläche
- 19a, 19b, 19c: Rastnuten
- 19y,19z: Rastnuten
- 20: Zentralschlitz
- 21a, 21b, 21c: Radialschlitze
- 22: Anschlagfläche
- 23: Griff (von 7)
- 24a, 24b: Seitenteile (von 7)
- 25: Aufnahmeschlitz (in 7)
- 26: Langloch (von 7)
- 27: Mitnehmerstift
- 28: Pfeil
- 29a, 29b: Langlöcher (von 8)
- 30: Sperrabsatz
- 31: Nocken
- 32: Schaltfläche
- 33: Druckfeder (in 7)
- 34: Raststift (in 7)
- 35: Querprofil
- 36: obere Begrenzungslinie
- 37: untere Begrenzungslinie

## Patentansprüche

1. Vorrichtung zum Ein- und Aushebeln einer Steckbaugruppe in bzw. aus einem Baugruppenträger, mit
- einem im Frontbereich der Steckbaugruppe (1) angeordneten Eckstück (3);
- einem Hebelziehgriff (4) mit einem an dem Eckstück (3) schwenkbar gelagerten Hebel (6), dessen kurzer Hebelarm (12) sich gegen ein Querprofil (35) des Baugruppenträgers abstützt;
**gekennzeichnet durch** ein auf dem langen Hebelarm (13) des Hebels (6) drehbar gelagertes Griffstück (7), das in unterschiedlichen Winkelpositionen kraftschlüssig mit dem Hebelarm (13) verbindbar ist, um den Hebel (6) zu verschwenken.

2. Vorrichtung nach Anspruch 1, **dadurch gekennzeichnet, dass** das Griffstück (7) nur bei bestimmten ausgewählten Winkelpositionen kraftschlüssig mit dem Hebelarm (13) verbindbar ist.

3. Vorrichtung nach Anspruch 2, **dadurch gekennzeichnet, dass** das Griffstück (7) in Längsrichtung verschieblich ist zwischen einer Ausgangslage, in der das Griffstück (7) frei drehbar ist, und einer Eingriffslage, in der das Griffstück (7) mit dem Hebelarm (13) kraftschlüssig verbunden ist.

4. Vorrichtung nach Anspruch 3, **dadurch gekennzeichnet, dass** an dem langen Hebelarm (13) eine Lagerachse (17) vorgesehen ist, die in ein Langloch (26) des Griffstücks (7) eingreift.

5. Vorrichtung nach Anspruch 3 oder 4, **dadurch gekennzeichnet, dass** das Griffstück (7) durch eine Druckfeder (33) in der Ausgangslage gehalten wird.

6. Vorrichtung nach einem der Ansprüche 3 bis 5, **dadurch gekennzeichnet, dass** an dem Griffstück (7) und dem langen Hebelarm (13) korrespondierende Mittel zur Herstellung einer formschlüssigen Verbindung vorgesehen sind.

7. Vorrichtung nach Anspruch 4, **dadurch gekennzeichnet, dass** der lange Hebelarm (13) eine Kulissenführung (20, 21a, 21b, 21c) aufweist, in die ein Mitnehmerstift (27) des Griffstücks (7) eingreift.

8. Vorrichtung nach einem der Ansprüche 2 bis 5, **dadurch gekennzeichnet, dass** an dem langen Hebelarm (13) und dem Griffstück (7) miteinander korrespondierende Rastmittel (19a, 19b, 19c; 34) vorgesehen sind, welche das Griffstück (7) in vorgegebenen Winkelpositionen fixiert.

9. Vorrichtung nach einem der Ansprüche 6 bis 8, **dadurch gekennzeichnet, dass** die durch die Rastmittel (19a, 19b, 19c; 34) fixierbaren Winkelpositionen den ausgewählten Winkelpositionen entsprechen, bei denen das Griffstück (7) an den Hebelarm (13) kraftschlüssig ankoppelbar ist.

10. Vorrichtung nach einem der Ansprüche 3 bis 9, **gekennzeichnet durch** eine am Eckstück (3) der Steckbaugruppe (1) in Längsrichtung verschieblich gelagerte Schubstange (8), die den Hebel (6) gegen Verschwenken verriegelt und **durch** das Griffstück (7) aus der Verriegelungslage in eine Entriegelungslage verschiebbar ist, wenn sich das Griffstück (7) in einer bestimmten ausgewählten Winkelposition befindet.

11. Vorrichtung nach Anspruch 10, **dadurch gekennzeichnet , dass** die Schubstange (8) einen Mikroschalter (10) zum Aktiv- bzw. Passivschalten der Steckbaugruppe (1) betätigt.

12. Vorrichtung nach Anspruch 10 oder 11, **dadurch gekennzeichnet, dass** die Schubstange (8) durch eine Zugfeder (11) in Richtung der Frontplatte der Steckbaugruppe (1) gezogen wird.

## Geänderte Patentansprüche

### Geänderte Patentansprüche gemäss Regel 86(2) EPÜ.

**1.** Vorrichtung zum Ein- und Aushebeln einer Steckbaugruppe in bzw. aus einem Baugruppenträger, mit
- einem im Frontbereich der Steckbaugruppe (1) angeordneten Eckstück (3);
- einem Hebelziehgriff (4) mit einem an dem Eckstück (3) schwenkbar gelagerten Hebel (6), dessen kurzer Hebelarm (12) sich gegen ein Querprofil (35) des Baugruppenträgers abstützt;
- einem auf dem langen Hebelarm (13) des Hebels (6) drehbar gelagerten Griffstück (7);
**dadurch gekennzeichnet, dass** das Griffstück (7) zudem in Längsrichtung verschieblich ist zwischen einer Ausgangslage, in der das Griffstück (7) frei drehbar ist, und einer Eingriffslage, in der das Griffstück (7) mit dem Hebelarm (13) kraftschlüssig verbunden ist, um den Hebel (6) zu verschwenken.

**2.** Vorrichtung nach Anspruch 1, **dadurch gekennzeichnet, dass** das Griffstück (7) nur bei bestimmten ausgewählten Winkelpositionen kraftschlüssig mit dem Hebelarm (13) verbindbar ist.

**3.** Vorrichtung nach Anspruch 1 oder 2, **dadurch gekennzeichnet, dass** an dem langen Hebelarm (13) eine Lagerachse (17) vorgesehen ist, die in ein Langloch (26) des Griffstücks (7) eingreift.

**4.** Vorrichtung nach einem der Ansprüche 1 bis 3, **dadurch gekennzeichnet, dass** das Griffstück (7) durch eine Druckfeder (33) in der Ausgangslage gehalten wird.

**5.** Vorrichtung nach einem der Ansprüche 1 bis 4, **dadurch gekennzeichnet, dass** an dem Griffstück (7) und dem langen Hebelarm (13) korrespondierende Mittel zur Herstellung einer formschlüssigen Verbindung vorgesehen sind.

**6.** Vorrichtung nach Anspruch 5, **dadurch gekennzeichnet, dass** der lange Hebelarm (13) eine Kulissenführung (20, 21a, 21b, 21c) aufweist, in die ein Mitnehmerstift (27) des Griffstücks (7) eingreift.

**7.** Vorrichtung nach einem der Ansprüche 2 bis 6, **dadurch gekennzeichnet, dass** an dem langen Hebelarm (13) und dem Griffstück (7) miteinander korrespondierende Rastmittel (19a, 19b, 19c; 34) vorgesehen sind, welche das Griffstück (7) in den vorgegebenen Winkelpositionen fixiert.

**8.** Vorrichtung nach Anspruch 7, **dadurch gekennzeichnet, dass** die durch die Rastmittel (19a, 19b, 19c; 34) fixierbaren Winkelpositionen den ausgewählten Winkelpositionen entsprechen, bei denen das Griffstück (7) an den Hebelarm (13) kraftschlüssig ankoppelbar ist.

**9.** Vorrichtung nach einem der Ansprüche 2 bis 8, **gekennzeichnet durch** eine am Eckstück (3) der Steckbaugruppe (1) in Längsrichtung verschieblich gelagerte Schubstange (8), die den Hebel (6) gegen Verschwenken verriegelt und **durch** das Griffstück (7) aus der Verriegelungslage in eine Entriegelungslage verschiebbar ist, wenn sich das Griffstück (7) in einer bestimmten ausgewählten Winkelposition befindet.

**10.** Vorrichtung nach Anspruch 9, **dadurch gekennzeichnet, dass** die Schubstange (8) einen Mikroschalter (10) zum Aktiv- bzw. Passivschalten der Steckbaugruppe (1) betätigt.

**11.** Vorrichtung nach Anspruch 9 oder 10, **dadurch gekennzeichnet, dass** die Schubstange (8) durch eine Zugfeder (11) in Richtung der Frontplatte der Steckbaugruppe (1) gezogen wird.
